# EUROPEAN PATENT SPECIFICATION

(11) **EP 4 187 788 B1**
(45) Date of publication and mention of the grant of the patent: **19.02.2025**
(21) Application number: 21306652.5
(22) Date of filing: 29.11.2021
(51) Int. Cl.: H03K 17/22

(54) **BIASING SYSTEM FOR STARTUP CIRCUITS IN SLEEP AND NORMAL MODES**
VORSPANNUNGSSYSTEM FÜR ANLAUFSCHALTUNGEN IM SCHLAF- UND NORMALMODUS
SYSTÈME DE POLARISATION POUR CIRCUITS DE DÉMARRAGE EN MODE VEILLE ET EN MODE NORMAL

(43) Date of publication of application: 31.05.2023
(73) Proprietor: NXP USA, Inc., Austin TX 78735 (US)
(72) Inventor: LORENZO SEVA CASSAGNES, Alejandra, 31023 Toulouse (FR); TURPIN, Pierre, 31023 Toulouse (FR); VEDELAGO, Juliette Angèle, 31023 Toulouse (FR)
(74) Representative: Hardingham, Christopher Mark

(56) References cited:
- US-A1- 2014 002 045
- US-A1- 2016 308 512

## Description

### BACKGROUND

### Field of the Invention

This disclosure relates to integrated circuits, and more particularly to startup circuits that generate a reference voltage for other circuits.

### Description of the Related Art

Typical integrated circuit systems (e.g., a power management systems) require startup circuitry to provide biasing signals that must be present even when the product is shut down or in another energy-saving mode (e.g., a sleep mode or deep sleep mode) of operation. The startup circuit triggers a wake-up sequence of the integrated circuit system in response to arrival of a wake-up signal. In general, in an energy-saving mode of operation, the startup circuit is operational, but the remainder of the integrated circuit system is shut down. Since the startup circuitry is always on, it is preferable that the startup circuitry consume low or negligible amounts of power. Typical startup circuitry is coupled to a power-on-reset circuit that resets the integrated circuit system when its supply voltage is too low to guarantee proper operation. Due to its low quiescent current, the startup circuit is sensitive to noise (e.g., noise injected from other circuits like an enabled DC-DC converter after wake-up of the integrated circuit). Such sensitivity to noise may cause a failure of the startup circuit, thereby causing a reset of the integrated circuit system (e.g., a power-on-reset) making the electronic product unusable. Accordingly, improved startup techniques are desired.

United States patent application, publication number US 2016 308512 discloses a clock generation circuit with fast-start-up standby mode. In standby mode, a small bias current is applied to amplifiers in the clock generation circuit, which bias voltages on internal nodes to very near their operating voltage values (i.e., in ON mode). This reduces transient perturbations on signals as the clock generation circuit is returned to ON mode.

United States patent application, publication number US 2014 002045 discloses an analogue circuit configured for fast, accurate start-up. According to one implementation, a circuit includes a steady-state block including steady-state circuitry, a load coupled to the steady-state circuitry and representing a load condition, and a steady-state bias current source configured to provide a steady-state bias current to the steady-state circuitry during steady-state operation. A startup block includes startup circuitry and a startup bias current source configured to provide a startup bias current to the startup circuitry during a startup mode. The startup bias current is substantially larger than the steady-state bias current. The startup circuitry has operational characteristics substantially similar to the steady-state circuitry but without the load condition such that, during the startup mode, the startup circuitry is configured to drive a common node to which both the startup circuitry and the steady-state circuitry are connected to a desired state. The desired state is substantially the same as achieved by the steady-state circuitry during steady-state operation with the load condition.

### BRIEF DESCRIPTION OF THE DRAWINGS

The present invention is illustrated by way of example and is not limited by the accompanying figures, in which like references indicate similar elements. Elements in the figures are illustrated for simplicity and clarity and have not necessarily been drawn to scale.
**Figure 1** illustrates a functional block diagram of an integrated circuit system including low-power startup circuitry and high-power circuitry.
**Figure 2** illustrates a circuit diagram of an integrated circuit system including low-power startup circuitry and high-power circuitry.
**Figure 3** illustrates a functional block diagram of an integrated circuit system including low-power startup circuitry and high-power circuitry providing supplemental current consistent with at least one embodiment of the invention.
**Figure 4** illustrates a circuit diagram of an integrated circuit system including low-power startup circuitry and high-power circuitry consistent with at least one embodiment of the invention.

The use of the same reference symbols in different drawings indicates similar or identical items.

### DETAILED DESCRIPTION

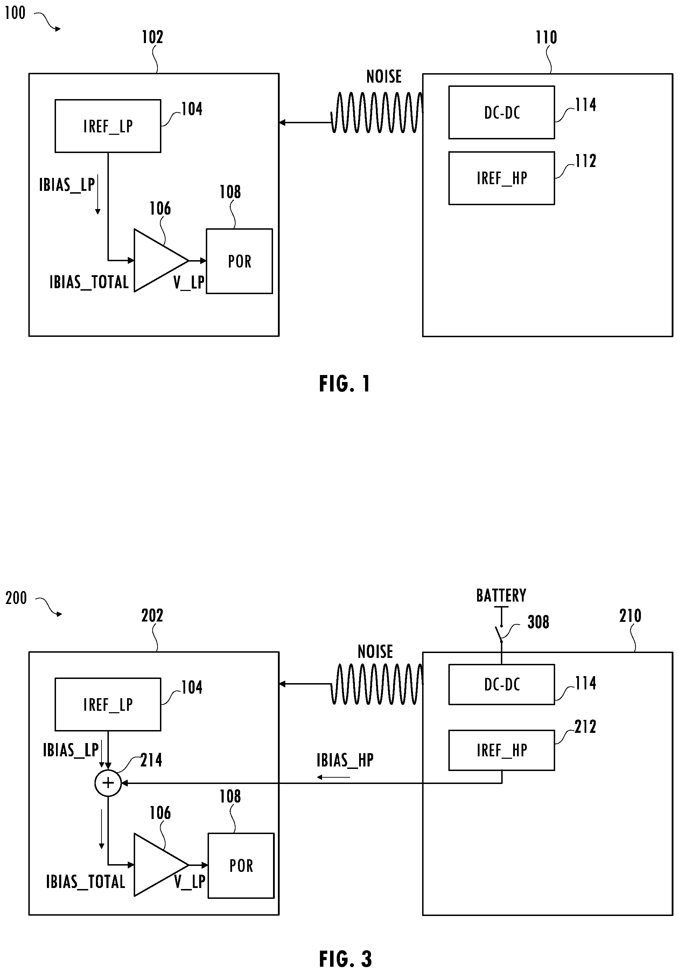

Referring to Fig. 1, useful for understanding the invention, integrated circuit system 100 has a startup mode of operation and at least one energy-saving mode of operation. First circuit 102 generates a reference voltage for power-on-reset circuit 108. First circuit 102 includes low-power current reference 104 and power-on-reset circuit 108 that use a very low bias current, which is ideally independent of temperature and voltage supply variations. Power-on-reset circuit 108 holds integrated circuit system 100 in a reset state until voltage V_LP meets a minimum threshold voltage level. First circuit 102 is always enabled and is never turned off from battery power. First circuit 102 detects wake-up events and triggers a wake-up sequence of integrated circuit system 100. The low-power circuitry of first circuit 102 is sensitive to noise. Second circuit 110 includes high-power circuitry (e.g., DC-DC converter 114 coupled to a battery (not shown) and high-power current reference 112), which in a normal mode of operation, injects noise into first circuit 102.

In an energy-saving mode of operation, current IBIAS_LP, which is generated by low-power current reference 104, equals current IBIAS_TOTAL, which is the total low-power bias current. Driver 106 converts current IBIAS_TOTAL to voltage V_LP that is a low-power reference signal for power-on-reset circuit 108. Power-on-reset circuit 108 uses the reference voltage in the normal mode of operation, in addition to in the energy-saving mode. However, in the normal mode of operation, current IBIAS_TOTAL varies with noise injected by second circuit 110 into first circuit 102. At times, that variation causes current IBIAS_TOTAL to be approximately zero, which causes power-on-reset circuit 108 to trigger a power-on-reset event. Conventional techniques for preventing the unwanted power-on-reset event include using a standby regulator and switching the biasing system (e.g., between a low-power biasing system or a high-power biasing system) in response to whether the product is in an energy-saving mode of operation or a normal mode of operation accordingly.

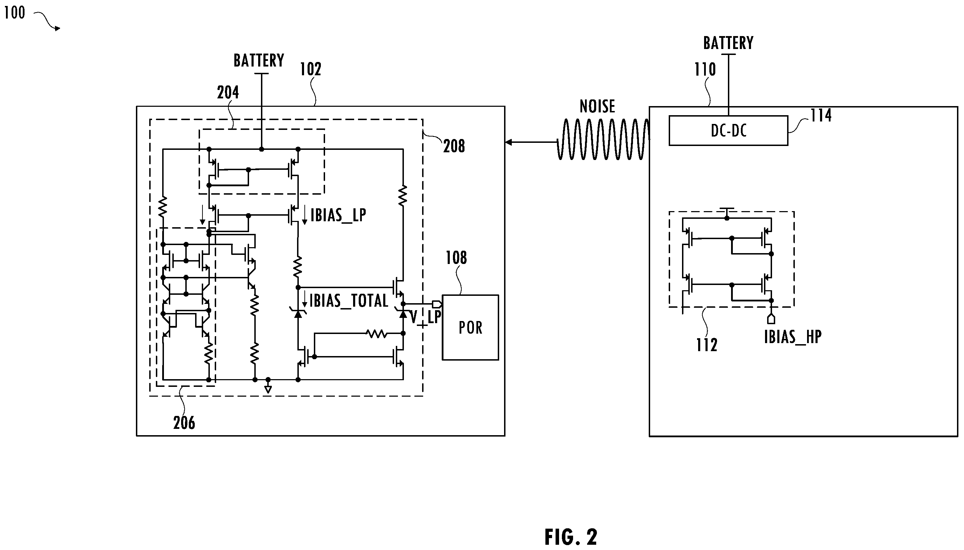

Referring to Fig. 2, the first circuit 102 of figure 1 includes startup circuit 208, which provides voltage V_LP to power-on-reset circuit 108. Second circuit 110 includes high power circuitry that receives a bias current IBIAS_HP generated based on a reference voltage provided by DC-DC conversion of a voltage provided by a battery. In at least one embodiment, startup circuit 208 includes bandgap voltage reference 206 and current mirror 204, which provides current IBIAS_LP, although other circuits may be used. Startup circuit 208 includes Zener diodes and additional devices (e.g., additional n-type transistors and a resistor) that are configured to convert current IBIAS _TOTAL to voltage V_LP having a predetermined voltage level. In at least one embodiment, bandgap voltage reference 206 includes bipolar transistors, which are sensitive to noise. During a wake-up event or normal mode of operation, second circuit 110 injects a substantial amount of noise into first circuit 102. At times, that noise is sufficient to cause current IBIAS_LP to drop or equal zero, thereby causing voltage V_LP to drop below a predetermined threshold voltage, which causes power-on-reset circuit 108 to trigger a power-on-reset event.

Referring to Fig. 3, in at least one embodiment, integrated circuit system 200 includes first circuit 202 having low-power circuitry including low-power current reference 104, driver 106, power-on-reset circuit 108, and summing circuit 214. Second circuit 210 includes a high-power current reference 212, which generates current IBIAS_HP during a wake-up event or in a normal mode of operation. In at least one embodiment, switch 308 selectively couples circuit 210 to a power supply according to the active mode of operation of system 200 (e.g., switch 308 is closed during a wake-up event or in a normal mode of operation and is open in an energy-saving mode of operation), although other circuit techniques may be used to configure circuit 210 according to the active mode of operation. In at least one embodiment, current IBIAS_HP generates various currents for integrated circuit 200 and provides a supplemental current that is dedicated to first circuit 202 (i.e., is not used elsewhere in integrated circuit 200). High-power current reference 212 does not generate current IBIAS_HP in any energy-saving mode of operation. Current IBIAS_HP is not sensitive to noise. In at least one embodiment, high-power current reference 212 (e.g., generating microamps) has a much lower impedance than low-power current reference 104 (e.g., generating hundreds of nanoamps). The higher impedance (e.g., at least one order of magnitude) of low-power current reference 104 attenuates any noise injected by parasitic capacitors (e.g., due to substrate or conductive routing). In at least one embodiment, high-power current reference 212 uses an intermediate regulated or cascaded power supply (e.g., 5 V) that rejects noise from the power supply (e.g., 40 V). In at least one embodiment, high-power current reference 212 includes a current mirror circuit coupled to a bandgap current reference or a bandgap voltage reference coupled to a resistor. In at least one embodiment, low-power current reference 104 is coupled directly to the power supply since an intermediate regulated or cascaded power supply would increase power consumption. When second circuit 210 is configured in an energy-saving mode of operation, second circuit 210 does not generate current IBIAS_HP. High-power current reference IREF_HP 212 provides current IBIAS_HP to summing circuit 214 in first circuit 202.

In at least one embodiment, summing circuit 214 receives current IBIAS_HP from second circuit 210. In at least one embodiment, summing circuit 214 is a summing node, although other circuits may be used (e.g., a summing amplifier). In at least one embodiment, summing circuit 214 includes an error amplifier biased by current IBIAS_HP coupled in parallel with another error amplifier biased by current IBIAS_LP and provides a current that is the sum of the output currents. Summing circuit 214 combines current IBIAS_LP and current IBIAS_HP to generate current IBIAS_TOTAL. Driver 106 converts current IBIAS _TOTAL to voltage V_LP and provides voltage V_LP to power-on-reset circuit 108. In a normal mode of operation, current IBIAS_TOTAL is equal to the sum of current IBIAS_LP and current IBIAS_HP. In an energy-saving mode of operation, current IBIAS_TOTAL equals current IBIAS_LP since IBIAS_HP is not generated by second circuit 210. No switching is required to turn off current IBIAS_HP since in the energy-saving mode of operation, second circuit 210 is powered-down and high-power current source 212 does not generate current IBIAS_HP, making current IBIAS_HP equal to zero.

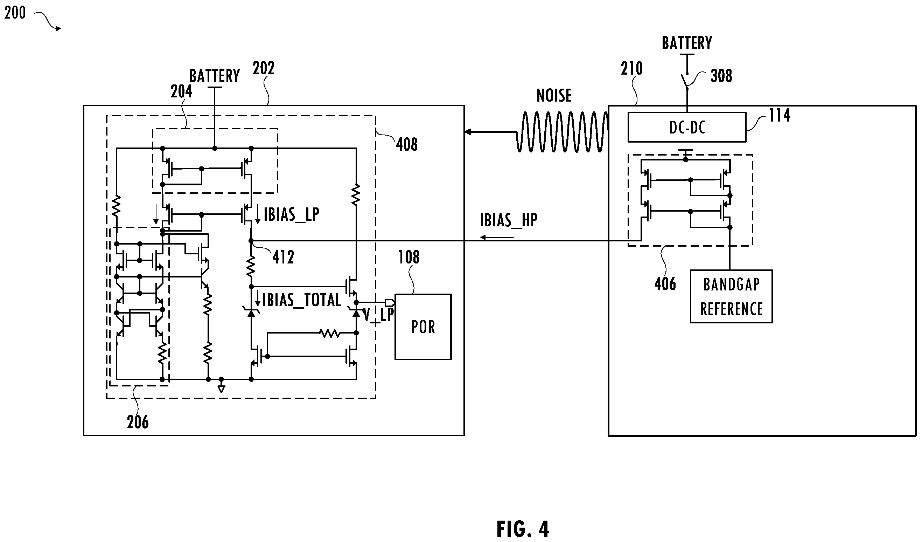

Referring to Fig. 4, in at least one embodiment, second circuit 210 provides current IBIAS_HP to startup circuit 408. Current mirror 406 provides current IBIAS_HP in a normal mode of operation of second circuit 210. Since second circuit 210 is powered-down in any energy-saving modes of operation, current IBIAS_HP is not generated in those modes of operation. Accordingly, no digital control logic or switches are needed to provide current IBIAS_HP to first circuit 202 in the normal mode of operation but not in the energy-saving mode of operation and the power consumption of first circuit 202 does not increase in the energy-saving mode of operation as compared to the system of Figs. 1 and 2.

Referring to Fig. 4, even if a substantial amount of noise is injected into first circuit 202 in a normal mode of operation that at times is sufficient to cause current IBIAS_LP to fall or equal zero, current IBIAS_HP is not sensitive to noise and remains non-zero. Thus, when current IBIAS_LP equals zero, current IBIAS_TOTAL equals current IBIAS_HP and voltage V_LP remains above the predetermined threshold level and powers power-on-reset circuit 108. Accordingly, no power-on-reset event is triggered by noise alone. Power-on-reset circuit 108 is exemplary only. In other embodiments, the biasing technique disclosed herein is used to provide current IBIAS_TOTAL to other circuits that are functional in an energy-saving mode of operation and in a normal mode of operation.

In at least one embodiment, first circuit 202 and second circuit 210 are formed on the same integrated circuit die but operate with different voltage reference levels. In at least one embodiment, first circuit 202 and second circuit 210 are separate integrated circuit die and each includes a bonding pad dedicated to providing current IBIAS_HP to summing node 412. In at least one embodiment, first circuit 202 and second circuit 210 are packaged separately and each include a terminal dedicated to providing current IBIAS_HP to summing node 412. Accordingly, absent any noise, current IBIAS_LP and voltage V_LP have the same levels in the energy saving mode as in the normal mode. In at least one embodiment, the battery has a voltage of 14 V, DC-DC converter 114 provides a voltage of 3.6 V, voltage V_LP is 5 V, current IBIAS_HP is approximately 1.7 µA, and current IBIAS_LP is approximately 1.6 µA. However, other operating points may be used.

In at least one embodiment, an integrated circuit system has an energy-saving mode of operation and a normal mode of operation. The integrated circuit system includes a circuit configured to use a reference signal in the energy-saving mode of operation and in the normal mode of operation. The integrated circuit system includes a startup circuit configured to provide the reference signal based on a bias signal. The bias signal is generated based on a first bias signal in the energy-saving mode and is generated based on the first bias signal and a second bias signal in the normal mode. The first bias signal is generated in the energy-saving mode and the normal mode. The second bias signal is generated in the normal mode and is not generated in the energy-saving mode.

In an embodiment, the integrated circuit system further includes a first circuit comprising the circuit and the startup circuit. A second circuit is configured to be powered-down in the energy-saving mode and to operate in the normal mode of the integrated circuit system. The second circuit provides the second bias signal to the startup circuit in the normal mode.

In an embodiment, the second circuit includes a switching circuit, the switching circuit injecting noise into the first circuit in the normal mode.

In an embodiment, the second circuit further includes a current mirror coupled to a bandgap reference circuit. The current mirror is configured to provide the second bias signal in the normal mode.

In an embodiment, the integrated circuit system further includes a power source coupled to the first circuit and coupled to the second circuit.

In an embodiment, the startup circuit includes a summing node configured to combine the first bias signal and the second bias signal.

The first bias signal is generated by a first current reference having a first impedance and the second bias signal is generated by a second current reference having a second impedance, the first impedance being at least one order of magnitude less than the second impedance.

In an embodiment, the first bias signal has a first level and the second bias signal has a second level. The second level is sufficient to maintain a non-zero bias current while maintaining the level of a reference signal at a target level.

In an embodiment, the startup circuit includes a bandgap voltage reference including bipolar transistors susceptible to noise.

In an embodiment, the startup circuit includes a current mirror coupled to the bandgap voltage reference and a Zener diode coupled to a voltage reference node providing the reference signal.

In at least one embodiment, a method for operating an integrated circuit system includes operating a circuit using a reference signal in an energy-saving mode of the integrated circuit system and in a normal mode of the integrated circuit system. The method includes generating the reference signal based on a first bias signal in an energy-saving mode of the integrated circuit system and based on the first bias signal and a second bias signal in a normal mode of the integrated circuit system. The first bias signal is generated in the energy-saving mode and in the normal mode. The second bias signal is generated in the normal mode and not generated in the energy-saving mode.

The method further includes generating the first bias signal using a first current reference having a first impedance and generating the second bias signal using a second current reference having a second impedance. The first impedance is at least one order of magnitude less than the second impedance.

In an embodiment, generating the reference signal comprises combining the first bias signal and the second bias signal using a summing node

In an embodiment, the method further includes generating the first bias signal in the energy-saving mode and in the normal mode, generating the second bias signal only in the normal mode, and converting a bias current to a reference voltage in the energy-saving mode and in the normal mode.

In an embodiment, the first bias signal has the same level in the energy-saving mode as in the normal mode.

In at least one embodiment, an integrated circuit system includes a first circuit configured to operate in an energy-saving mode of the integrated circuit system and in a normal mode of the integrated circuit system. The first circuit generates a reference signal based on a bias signal. The bias signal is generated based on a first bias signal in the energy-saving mode and is a sum of the first bias signal and a second bias signal in the normal mode. The first bias signal is generated in the energy-saving mode and in the normal mode. The second bias signal is generated in the normal mode and is not generated in the energy-saving mode. The integrated circuit system includes a second circuit configured to be powered-down in the energy-saving mode and to operate in the normal mode of the integrated circuit system, the second circuit providing the second bias signal to the first circuit in the normal mode.

In an embodiment, the first bias signal is generated by a first current reference having a first impedance and the second bias signal is generated by a second current reference having a second impedance, the first impedance being at least one order of magnitude less than the second impedance.

In an embodiment, the first circuit includes a startup circuit configured to generate the reference signal and a power-on-reset circuit configured to initiate a power-on-reset event in response to a level of the reference signal falling below a predetermined threshold level.

Thus, techniques for supplementing a default bias current of a startup circuit increases the immunity of the startup circuit to noise without substantially increasing power consumption in an energy-saving mode of operation. The technique does not require switching between biasing in the energy-saving mode and biasing in the wake-up mode. Rather, a supplemental current that is generated in the normal mode of operation (e.g., a mode of operation after a wake-up sequence and a DC-DC converter is enabled) automatically disappears in the energy-saving mode. The technique uses a supplemental current generated by a source that is external to the startup circuitry, thereby increasing diversity with respect to failure mechanisms.

Although the invention is described herein with reference to specific embodiments, various modifications and changes can be made without departing from the scope of the present invention as set forth in the claims below. For example, rather than use a buck converter for DC-DC converter 114, other DC-DC converters may be used. In addition, other circuits may be used for bandgap reference 206 or current mirror 204. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Unless stated otherwise, terms such as "first" and "second" are used to arbitrarily distinguish between the elements such terms describe. Thus, these terms are not necessarily intended to indicate temporal or other prioritization of such elements.

## Claims

1. An integrated circuit system (200) having an energy-saving mode of operation and a normal mode of operation, the integrated circuit system comprising:
a power-on-reset circuit (108) configured to use a reference signal (V_LP) in the energy-saving mode of operation and in the normal mode of operation to determine whether to trigger a power-on-reset event;
a startup circuit (408) configured to provide the reference signal based on a bias signal (IBIAS_TOTAL), the bias signal being generated based on a first bias signal (IBIAS_LP) in the energy-saving mode and being generated based on the first bias signal and a second bias signal (IBIAS_HP) in the normal mode, the first bias signal being generated in the energy-saving mode and the normal mode, the second bias signal being generated in the normal mode and not being generated in the energy-saving mode;.
a first current reference circuit having a first impedance and configured to generate the first bias signal; and
a second current reference circuit having a second impedance and configured to generate the second bias signal, the first impedance being at least one order of magnitude less than the second impedance.

2. The integrated circuit system as recited in claim 1 futher comprising:
a first circuit (202) comprising the circuit (108) and the startup circuit (408); and
a second circuit (210) configured to be powered-down in the energy-saving mode and to operate in the normal mode, the second circuit providing the second bias signal to the startup circuit in the normal mode.

3. The integrated circuit system as recited in claim 2 wherein the second circuit comprises a switching circuit (114), the switching circuit injecting noise into the first circuit in the normal mode.

4. The integrated circuit system as recited in claim 2 or 3, wherein the second circuit further comprises a current mirror (406) coupled to a bandgap reference circuit, the current mirror being configured to provide the second bias signal in the normal mode.

5. The integrated circuit system as recited in any preceding claim wherein the startup circuit comprises a summing node (412) configured to combine the first bias signal and the second bias signal.

6. The integrated circuit system as recited in any preceding claim wherein the first bias signal has a first level and the second bias signal has a second level, the second level being sufficient to maintain a non-zero bias current while maintaining a level of the reference signal at a target level.

7. The integrated circuit system as recited in any preceding claim wherein the startup circuit comprises:
a bandgap voltage reference including bipolar transistors susceptible to noise; and
a current mirror coupled to the bandgap voltage reference and a Zener diode coupled to a voltage reference node providing the reference signal.

8. The integrated circuit system as recited in any preceding claim, wherein the first bias signal is a current having the same level in the energy-saving mode and in the normal mode.

9. A method for operating an integrated circuit system (200), the method comprising:
operating a power-on-reset circuit (108), using a reference signal (V_LP) in an energy-saving mode of the integrated circuit system and in a normal mode of the integrated circuit system, to determine whether to trigger a power-on-reset event; and
generating the reference signal based on a first bias signal (IBIAS_LP) in the energy-saving mode of the integrated circuit system and based on the first bias signal and a second bias signal (IBIAS _HP) in the normal mode of the integrated circuit system, the first bias signal being generated in the energy-saving mode and in the normal mode, the second bias signal being generated in the normal mode and not being generated in the energy-saving mode; and further comprising:
generating the first bias signal using a first current reference having a first impedance; and
generating the second bias signal using a second current reference having a second impedance, the first impedance being at least one order of magnitude less than the second impedance.

10. The method as recited in claim 9 wherein generating the reference signal comprises combining the first bias signal and the second bias signal using a summing node.

11. The method as recited in any of claims 9 or to 10 wherein the first bias signal has a first level and the second bias signal has a second level, the second level being sufficient to maintain a non-zero bias current while maintaining a level of the reference signal at a target level.

12. The method as recited in any of claims 9 to 11, further comprising:
generating the first bias signal in the energy-saving mode and in the normal mode;
generating the second bias signal only in the normal mode; and
converting a bias current to a reference voltage in the energy-saving mode and in the normal mode.

13. The method as recited in any of claims 9 to 12 wherein the first bias signal has the same level in the energy-saving mode as in the normal mode.

## Patentansprüche

1. Integriertes Schaltungssystem (200) mit einem energiesparenden Betriebsmodus und einem normalen Betriebsmodus, wobei das integrierte Schaltungssystem Folgendes umfasst:
eine Einschalt-Rücksetzschaltung (108), die dafür ausgebildet ist, ein Referenzsignal (V_LP) im energiesparenden Betriebsmodus und im normalen Betriebsmodus zu verwenden, um zu bestimmen, ob ein Einschalt-Rücksetzereignis ausgelöst werden soll;
eine Anlaufschaltung (408), die dafür ausgebildet ist, das Referenzsignal auf der Grundlage eines Vorspannungssignals (IBIAS_TOTAL) bereitzustellen, wobei das Vorspannungssignal auf der Grundlage eines ersten Vorspannungssignals (IBIAS_LP) in dem Energiesparmodus erzeugt wird und auf der Grundlage des ersten Vorspannungssignals und eines zweiten Vorspannungssignals (IBIAS_HP) im Normalmodus erzeugt wird, wobei das erste Vorspannungssignal im Energiesparmodus und im Normalmodus erzeugt wird, das zweite Vorspannungssignal im Normalmodus erzeugt wird und im Energiesparmodus nicht erzeugt wird;
eine erste Stromreferenzschaltung, die eine erste Impedanz aufweist und dafür ausgebildet ist, das erste Vorspannungssignal zu erzeugen; und
eine zweite Stromreferenzschaltung mit einer zweiten Impedanz, die dafür ausgebildet ist, das zweite Vorspannungssignal zu erzeugen, wobei die erste Impedanz um mindestens eine Größenordnung kleiner als die zweite Impedanz ist.

2. Integriertes Schaltungssystem nach Anspruch 1, das ferner Folgendes umfasst:
eine erste Schaltung (202), die die Schaltung (108) und die Anlaufschaltung (408) umfasst; und
eine zweite Schaltung (210), die dafür ausgebildet ist, im Energiesparmodus ausgeschaltet zu werden und im Normalmodus zu arbeiten, wobei die zweite Schaltung das zweite Vorspannungssignal für die Anlaufschaltung im Normalmodus bereitstellt.

3. Integriertes Schaltungssystem nach Anspruch 2, wobei die zweite Schaltung einen Schaltkreis (114) umfasst, wobei der Schaltkreis im Normalmodus Rauschen in die erste Schaltung einspeist.

4. Integriertes Schaltungssystem nach Anspruch 2 oder 3, wobei die zweite Schaltung ferner einen Stromspiegel (406) umfasst, der mit einer Bandlücken-Referenzschaltung gekoppelt ist, wobei der Stromspiegel dafür ausgebildet ist, das zweite Vorspannungssignal im Normalmodus bereitzustellen.

5. Integriertes Schaltungssystem nach einem der vorhergehenden Ansprüche, wobei die Anlaufschaltung einen Summierknoten (412) umfasst, der für die Kombination des ersten Vorspannungssignals und des zweiten Vorspannungssignals ausgebildet ist.

6. Integriertes Schaltungssystem nach einem der vorhergehenden Ansprüche, wobei das erste Vorspannungssignal einen ersten Pegel und das zweite Vorspannungssignal einen zweiten Pegel hat, wobei der zweite Pegel ausreicht, um einen Vorspannungsstrom ungleich Null aufrechtzuerhalten, während ein Pegel des Referenzsignals auf einem Zielpegel gehalten wird.

7. Integriertes Schaltungssystem nach einem der vorhergehenden Ansprüche, wobei die Anlaufschaltung Folgendes umfasst:
eine Bandlücken-Spannungsreferenz, die rauschanfällige bipolare Transistoren einschließt; und
einen Stromspiegel, der mit der Bandlücken-Spannungsreferenz gekoppelt ist, und eine Zener-Diode, die mit einem Spannungsreferenzknoten gekoppelt ist, der das Referenzsignal bereitstellt.

8. Integriertes Schaltungssystem nach einem der vorhergehenden Ansprüche, wobei das erste Vorspannungssignal ein Strom ist, der im Energiesparmodus und im Normalmodus den gleichen Pegel hat.

9. Verfahren zum Betreiben eines integrierten Schaltungssystems (200), wobei das Verfahren Folgendes umfasst:
Betreiben einer Einschalt-Rücksetzschaltung (108), die ein Referenzsignal (V_LP) in einem Energiesparmodus des integrierten Schaltungssystems und in einem Normalmodus des integrierten Schaltungssystems verwendet, um zu bestimmen, ob ein Einschalt-Rücksetzereignis ausgelöst werden soll; und
Erzeugen des Referenzsignals auf der Grundlage eines ersten Vorspannungssignals (IBIAS_LP) im Energiesparmodus des integrierten Schaltungssystems und auf der Grundlage des ersten Vorspannungssignals und eines zweiten Vorspannungssignals (IBIAS_HP) im Normalmodus des integrierten Schaltungssystems, wobei das erste Vorspannungssignal im Energiesparmodus und im Normalmodus erzeugt wird, das zweite Vorspannungssignal im Normalmodus erzeugt wird und im Energiesparmodus nicht erzeugt wird; und ferner umfassend:
Erzeugen des ersten Vorspannungssignals unter Verwendung einer ersten Stromreferenz mit einer ersten Impedanz; und Erzeugen des zweiten Vorspannungssignals unter Verwendung einer zweiten Stromreferenz mit einer zweiten Impedanz, wobei die erste Impedanz um mindestens eine Größenordnung kleiner als die zweite Impedanz ist.

10. Verfahren nach Anspruch 9, wobei das Erzeugen des Referenzsignals das Kombinieren des ersten Vorspannungssignals und des zweiten Vorspannungssignals unter Verwendung eines Summierknotens umfasst.

11. Verfahren nach einem der Ansprüche 9 oder 10, wobei das erste Vorspannungssignal einen ersten Pegel und das zweite Vorspannungssignal einen zweiten Pegel hat, wobei der zweite Pegel ausreicht, um einen Vorspannungsstrom ungleich Null aufrechtzuerhalten, während ein Pegel des Referenzsignals auf einem Zielpegel gehalten wird.

12. Verfahren nach einem der Ansprüche 9 bis 11, das ferner Folgendes umfasst:
Erzeugen des ersten Vorspannungssignals im Energiesparmodus und im Normalmodus;
Erzeugen des zweiten Vorspannungssignals nur im Normalmodus; und
Umwandeln eines Vorspannungsstroms in eine Referenzspannung im Energiesparmodus und im Normalmodus.

13. Verfahren nach einem der Ansprüche 9 bis 12, wobei das erste Vorspannungssignal im Energiesparmodus den gleichen Pegel wie im Normalmodus aufweist.

## Revendications

1. Système de circuit intégré (200) ayant un mode de fonctionnement en économie d'énergie et un mode de fonctionnement normal, le système de circuit intégré comprenant :
un circuit de réinitialisation (108) configuré pour utiliser un signal de référence (V_LP) au mode de fonctionnement en économie d'énergie et au mode de fonctionnement normal pour déterminer s'il faut ou non déclencher un événement de réinitialisation ;
un circuit de démarrage (408) configuré pour fournir le signal de référence en fonction d'un signal de polarisation (IBIAS_TOTAL), le signal de polarisation étant généré sur la base d'un premier signal de polarisation (IBIAS_LP) au mode économie d'énergie et étant généré sur la base du premier signal de polarisation et d'un second signal de polarisation (IBIAS _HP) au mode normal, le premier signal de polarisation étant généré au mode économie d'énergie et au mode normal, le second signal de polarisation étant généré au mode normal et n'étant pas généré au mode économie d'énergie ;
un premier circuit de référence de courant ayant une première impédance et étant configuré pour générer le premier signal de polarisation ; et
un second circuit de référence de courant ayant une seconde impédance et étant configuré pour générer le second signal de polarisation, la première impédance étant inférieure d'au moins un ordre de grandeur à la seconde impédance.

2. Système de circuit intégré selon la revendication 1, comprenant en outre :
un premier circuit (202) comprenant le circuit (108) et le circuit de démarrage (408) ; et
un second circuit (210) configuré pour être éteint au mode économie d'énergie et pour fonctionner au mode normal, le second circuit fournissant le second signal de polarisation au circuit de redémarrage au mode normal.

3. Système de circuit intégré selon la revendication 2, dans lequel le second circuit comprend un circuit de commutation (114), le circuit de commutation injectant du bruit dans le premier circuit au mode normal.

4. Système de circuit intégré selon la revendication 2 ou 3, dans lequel le second circuit comprend en outre un miroir de courant (406) couplé à un circuit de référence à bande interdite, le miroir de courant étant configuré pour fournir le second signal de polarisation au mode normal.

5. Système de circuit intégré selon l'une quelconque des revendications précédentes, dans lequel le circuit de démarrage comprend un nœud de sommation (412) configuré pour combiner le premier signal de polarisation et le second signal de polarisation.

6. Système de circuit intégré selon l'une quelconque des revendications précédentes, dans lequel le premier signal de polarisation a un premier niveau et le second signal de polarisation a un second niveau, le second niveau étant suffisant pour maintenant un courant de polarisation non nul tout en maintenant un niveau du signal de référence à un niveau cible.

7. Système de circuit intégré selon l'une quelconque des revendications précédentes, dans lequel le circuit de démarrage comprend :
une référence de tension à bande interdite incluant des transistors bipolaires sensibles au bruit ; et
un miroir de courant couplé à la référence de tension à bande interdite et une diode Zener couplée à un nœud de référence de tension fournissant le signal de référence.

8. Système de circuit intégré selon l'une quelconque des revendications précédentes, dans lequel le premier signal de polarisation est un courant ayant le même niveau au mode économie d'énergie et au mode normal.

9. Procédé de fonctionnement d'un système de circuit intégré (200), le procédé comprenant :
l'actionnement d'un circuit de réinitialisation (108), en utilisant un signal de référence (V_LP) dans un mode économie d'énergie du système de circuit intégré et dans un mode normal du système de circuit intégré, pour déterminer s'il faut ou non déclencher un événement de réinitialisation ; et
la génération du signal de référence sur la base d'un premier signal de polarisation (IBIAS_LP) au mode économie d'énergie du système de circuit intégré et sur la base du premier signal de polarisation et d'un second signal de polarisation (IBIAS_HP) au mode normal du système de circuit intégré, le premier signal de polarisation étant généré au mode économie d'énergie et au mode normal, le second signal de polarisation étant généré au mode normal et n'étant pas généré au mode économie d'énergie ; et comprenant en outre :
la génération du premier signal de polarisation en utilisant une première référence de courant ayant une première impédance ; et
la génération du second signal de polarisation en utilisant une seconde référence de courant ayant une seconde impédance, la première impédance étant inférieure d'au moins un ordre de grandeur à la seconde impédance.

10. Procédé selon la revendication 9, dans lequel la génération du signal de référence comprend la combinaison du premier signal de polarisation et du second signal de polarisation au moyen d'un nœud de sommation.

11. Procédé selon l'une quelconque des revendications 9 ou 10, dans lequel le premier signal de polarisation a un premier niveau et le second signal de polarisation a un second niveau, le second niveau étant suffisant pour maintenant un courant de polarisation non nul tout en maintenant un niveau du signal de référence à un niveau cible.

12. Procédé selon l'une quelconque des revendications 9 à 11, comprenant en outre :
la génération du premier signal de polarisation au mode économie d'énergie et au mode normal ;
la génération du second signal de polarisation uniquement au mode normal ; et
la conversion d'un courant de polarisation à une tension de référence au mode économie d'énergie et au mode normal.

13. Procédé selon l'une quelconque des revendications 9 à 12, dans lequel le premier signal de polarisation a le même niveau au mode économie d'énergie et au mode normal.
